Europäisches Patentamt

European Patent Office

Office européen des brevets

(19)

(11) **EP 1 367 533 B1**

(12) **EUROPÄISCHE PATENTSCHRIFT**

(45) Veröffentlichungstag und Bekanntmachung des Hinweises auf die Patenterteilung:
**26.10.2005 Patentblatt 2005/43**

(51) Int Cl.⁷: **G06K 19/077**, H05K 3/00, B23Q 17/22

(21) Anmeldenummer: **03011850.9**

(22) Anmeldetag: **26.05.2003**

(54) **Freilegevorrichtung zum Freilegen von elektrisch leitenden Materialen in nicht leitenden Trägern sowie Verfahren zur Steuerung der Freilegevorrichtung**

Uncovering device for uncovering of electrically conductive materials in non-conductive supports and method for controlling the uncovering device

Dispositif de dégarnissage pour dégarnir de matériaux électriquement conducteurs dans des supports non-conducteurs et procédé pour controler le dispositif de dégarnissage

(84) Benannte Vertragsstaaten:
**CH DE FI FR IT LI**

(30) Priorität: **27.05.2002 DE 10223509**

(43) Veröffentlichungstag der Anmeldung:
**03.12.2003 Patentblatt 2003/49**

(73) Patentinhaber: **Mühlbauer AG**
**93426 Roding (DE)**

(72) Erfinder: **Höcherl, Matthias**
**93426 Roding (DE)**

(74) Vertreter: **Grünecker, Kinkeldey,**
**Stockmair & Schwanhäusser Anwaltssozietät**
**Maximilianstrasse 58**
**80538 München (DE)**

(56) Entgegenhaltungen:
**DE-C- 19 720 226          FR-A- 2 798 873**

**Beschreibung**

Diese Erfindung betrifft eine Freilegevorrichtung gemäß den Oberbegriffen der Patentansprüche 1 oder 2 sowie ein Verfahren gemäß den Oberbegriffen der Patentansprüche 13 oder 17.

Eine solche Freilegevorrichtung ist aus der DE 197 20 226 C1 bekannt.

In Trägermaterialien für Chipkarten, wie zum Beispiel für Kontaktlos- oder Dualinterface-Chipkarten, ist eine Innenlage aus elektrisch leitendem Material eingelassen, die zum Beispiel eine Antennenspule für das Senden und/oder Empfangen von Daten bildet.

Um die Innenlage, insbesondere die Spule an einen Chip anschließen zu können, wird in der EP 0 671 705 A2 vorgeschlagen, schon bei der Fertigung eine Öffnung dort zu lassen, wo sich die Kontakte befinden. Dadurch wird jedoch die Fertigung der Kartenkörper wesentlich erschwert. Darüber hinaus ist die weitere Handhabung, wie Verpackung und Versand, derartig vorgefertigter Kartenkörper zu Kunden schwierig, weil die offen liegenden Kontaktpads beschädigt und oxidiert werden können und so der Kartenkörper unbrauchbar wird. Das Einsetzen von Chips kurz nach der Herstellung ist jedoch nicht möglich, wenn die Kunden individuelle Chips einsetzen wollen.

Zum Schutz der Kontaktflächen werden diese deshalb bei der Herstellung durch isolierendes Trägermaterial bedeckt. Später, nämlich kurz vor dem Einbau einer elektronischen Schaltung (IC: integrated circuit), werden dann die Kontaktflecken wieder frei gelegt.

Die Dicke des abzutragenden isolierenden Trägermaterials kann je nach Herstellungsverfahren stark schwanken. Die Innenlage kann beispielsweise durch Drucken, Ätzen oder Verlegen der Antennenstruktur hergestellt werden. In einem Fräsvorgang werden dann die Kontaktpads, die auch als Anschlusspads oder -pins bezeichnet werden und die elektrischen Anschlusspunkte zum Chip darstellen, frei gelegt. Da die Dicke des abzutragenden Trägermaterials stark schwanken kann und die Kontaktpads sehr dünn sind, ist es schwierig, die richtige Frästiefe einzustellen. Aus diesem Grund wurden Systeme entwickelt, die den Fräsvorgang automatisch stoppen, wenn der Fräser die Kontaktpads erreicht hat. Da allerdings zum Zeitpunkt des Fräservorgangs noch keine elektrische Verbindung zur Antenne möglich ist, sondern vielmehr der Fräser beim Freilegen des ersten Kontaktpads den ersten elektrischen Kontakt zur Innenlage herstellt, muss das Messsystem kontaktlos arbeiten und automatisch den Vorschub des Fräsers stoppen.

Eine Möglichkeit, den Zeitpunkt zu ermitteln, zu dem der Fräser einen elektrischen Kontakt zur Innenlage herstellt, besteht darin, unter der Karte eine Sende- und Empfangsantenne anzubringen und diese mit einem Kondensator zu einem elektrischen Schwingkreis zu ergänzen. Sobald der Fräser die Innenlage berührt, ändert sich die Resonanzfrequenz des Schwingkreises.

Wird eine solche Änderung detektiert, wird der Fräser angehalten. Nachteilig ist beim Resonanzverfahren, dass die Streuung der Resonanzfrequenz einer Kartenart nur gering sein darf.

Aus der französischen Offenlegungsschrift FR-A-2 798 873 ist eine Freilegevorrichtung bekannt, bei welcher der Vorschub des Abtragewerkzeugs durch eine Schaltung angesteuert wird, welche die Kapazität zwischen einer auf der gegenüberliegenden Seite der Karte anaebrachten Elektrode und dem sich bei der Abtragung nähernden Fräser misst.

Eine andere Möglichkeit ist in der DE 197 20 226 C1 beschrieben. Konkret offenbart diese Schrift ein Verfahren und eine Vorrichtung zur Herstellung von Chipkarten. In der Vorrichtung kann der Chipkartenkörper zwischen einer Halteeinrichtung und einer Andruckplatte eingespannt werden. Im Chipkartenkörper sind beispielsweise Kontaktabschnitte sowie eine Spule bildende Leiterbahn eingelassen. Über den freizulegenden Kontaktabschnitten weist die Andruckplatte Bohrungen auf, durch die ein Fräskopf mittels eines Fräsers den Kartenkörper bearbeiten kann. Insbesondere dient der Fräser dazu, das über den Kontaktabschnitten befindliche Material des Kartenkörpers zu entfernen. Fräser, Fräskopf und Andruckplatte sind geerdet. In die Halteeinrichtung ist eine Elektrode eingelassen. Solange der Fräser noch keinen Kontaktabschnitt freigelegt hat, also keinen elektrischen Kontakt zu einem Kontaktabschnitt hat, wird zwischen Andruckplatte und Elektrode eine etwas höhere Kapazität gemessen, als wenn der Fräskopf elektrischen Kontakt zu einem Kontaktabschnitt und damit zu den Leiterbahnen hat. Diese Kapazitätsänderung wird durch eine Wheatstone'sche Brücke gemessen und zum Stoppen des Fräservorschubs verwendet.

Die bisherigen teilweise sehr teuren Systeme erfordern eine zeitaufwendige Justage auf die einzelnen Antennentypen.

Dieser Erfindung liegt die Aufgabe zugrunde, eine Freilegevorrichtung und ein Verfahren anzugeben, das keine zeitaufwendige Justage erfordert.

Diese Aufgabe wird durch die Gegenstände der unabhängigen Ansprüche gelöst.

Bevorzugte Ausführungsformen sind Gegenstand der abhängigen Ansprüche.

Vorteilhaft an der Verwendung von Abschirmelektroden zusammen mit einer Elektrode zum Erfassen einer Spannung ist, dass die Elektrode praktisch kein elektrisches Signal liefert, solange der Fräser noch weit von den frei zulegenden Kontaktpads entfernt ist. Es ist deshalb nicht erforderlich, wie in der DE 197 20 226 C1 vorgeschlagen, eine relativ kleine Änderung einer Kapazität durch eine Messbrücke zu detektieren oder eine kleine Veränderung einer Resonanzfrequenz zu detektieren.

Um die von der Elektrode gelieferte Spannung klein zu halten, wenn der Fräser lediglich in eine Aussparung im Niederhalter 18, 19 eintritt, aber der eigentliche Fräsvorgang noch gar nicht begonnen hat, ist ein Abstand zwischen Elektrode 10 und der Aussparung im Niederhalter 18, 19 vorgesehen.

Vorteilhaft an einer Steuerung der Vorschubgeschwindigkeit in Abhängigkeit von der Amplitude der von der Elektrode gelieferten Spannung und/oder von der Veränderung diese Amplitude ist, dass der Vorschub bereits bei der Annäherung des Fräsers an das Kontaktpad verlangsamt werden kann, so dass der Fräser das freizulegende Kontaktpad möglichst wenig beschädigt.

Vorteilhaft an einer kapazitiven Einkopplung der Wechselspannung auf den Fräser ist, dass der Fräser gegenüber seiner eigenen Antriebsmotorwelle elektrisch isoliert werden kann. Vorteilhaft ist ferner, dass bei Potentialunterschieden zwischen Fräser und Innenlage der Ausgleichsstrom zumindest beim ersten Kontakt zwischen Fäser und Innenlage klein ist und somit die Gefahr einer Beschädigung des Kontaktpads gering ist.

Vorteilhaft an der Verwendung eines ersten und zweiten Grenzwerts zum Abschalten des Vorschubs ist, dass der Vorschub unter Umständen eine Halbperiode der verwendeten Wechselspannung früher abgeschaltet wird.

Im Folgenden werden bevorzugte Ausgangsformen der Erfindung unter Bezugnahme auf die beiliegenden Zeichnungen näher erläutert. Dabei zeigen

Fig. 1 eine erste Ausführungsform einer erfindungsgemäßen Freilegevorrichtung;

Fig. 2 eine erste Schaltung für die in Fig. 1 dargestellte Freilegevorrichtung mit einer ersten Ausführungsform einer Auswerteelektronik;

Fig. 3 eine zweite Schaltung für die in Fig. 1 dargestellte Freilegevorrichtung mit einer ersten Ausführungsform der Auswerteelektronik;

Fig. 4 eine zweite Ausführungsform einer erfindungsgemäßen Freilegevorrichtung;

Fig. 5 eine Schaltung für die in Fig. 4 dargestellte Freilegevorrichtung mit der ersten Ausführungsform der Auswerteelektronik; und

Fig. 6 eine zweite Ausführungsform der Auswerteelektronik.

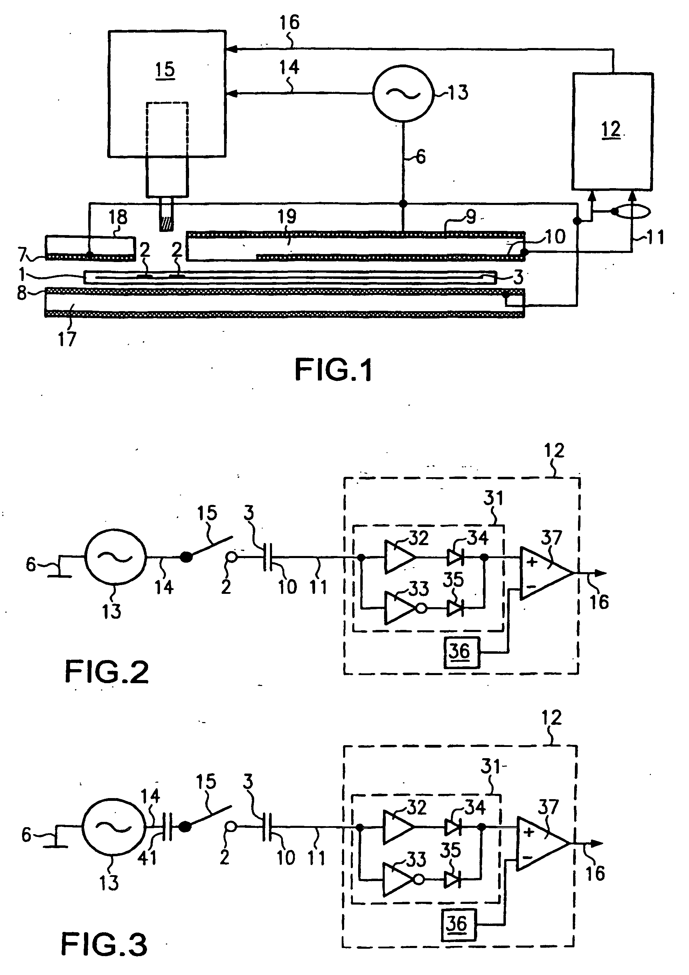

Fig. 1 zeigt eine erfindungsgemäße Freilegevorrichtung. Zum Freilegen der Kontaktpads 2 in der Chipkarte 1 wird die Chipkarte 1 zwischen eine Kartenauflage 17 und einen Niederhalter 18, 19 eingespannt. Der Niederhalter 18, 19 weist eine Aussparung für einen in einem elektrisch leitenden Fräskopf 15 montierten elektrisch leitenden Fräser auf, der die Kontaktpads 2 frei legen soll. Die Kartenauflage 17 sowie der Niederhalter 18, 19, weisen Abschirmelektroden 8, 9 und 7 auf, die elektrisch leitend verbunden sind und deren Potential als Planspannung 6 bezeichnet wird. Die Planspannung bildet das Bezugspotential für die elektrische Schaltung.

Die Planspannung kann gegenüber der Maschinenumgebung, insbesondere den Maschinererden, galvanisch getrennt werden. Zwischen Planspannung und Fräser wird durch einen Wechselspannungsgenerator 13 über einen Wechselspannungsanschluss 14 eine Wechselspannung angelegt.

Im Niederhalter ist eine Elektrode 10 angeordnet, die in einer Ausführungsform einen Abstand zu der Aussparung im Niederhalter 18, 19 für den Fräser aufweist. Wie im Zusammenhang mit den Fig. 2 bis 4 genauer erläutert wird, ist die Elektrode 10 mit der Auswerteelektronik 12 über Leitung 11 verbunden. Leitung 11 kann abgeschirmt sein. Sobald der Fräser ein Kontaktpad 2 berührt, liefert die Elektrode 10 ein nennenswertes Wechselspannungssignal, das in der Auswerteelektronik 12 detektiert wird und über Vorschubsteuerleitung 16 den Vorschub des Fräsers zunächst stoppt und veranlasst, dass der Fräser anschließend zurückgezogen wird und, falls erforderlich, das nächste Kontaktpad frei legt.

Fig. 2 zeigt ein Schaltbild der in Fig. 1 dargestellten Freilegevorrichtung, wobei die Auswerteelektronik 12 detaillierter dargestellt ist. Zwischen der Planspannung 6 und dem Fräser wird durch einen Wechselspannungsgenerator 13 über einen Wechselspannungsanschluss 14 eine Wechselspannung auf den Fräser gelegt. Ein lösbarer Kontakt stellt die Kontaktpads 2 dar. Die Innenlage 3 bildet zusammen mit der Elektrode 10 einen Kondensator. Über Leitung 11 wird die Spannung der Elektrode 10 dem Eingang der Auswerteelektronik 12 zugeführt.

Die Auswerteelektronik 12 umfasst einen Gleichrichterverstärker 31 sowie einen Vergleicher 37 sowie eine Referenzspannungsquelle 36. Liefert der Gleichrichterverstärker 31 eine höhere Spannung als die Referenzspannungsquelle 36, so gibt der Vergleicher 37 eine positive Spannung zum Stoppen des Fräservorschubs über die Vorschubsteuerleitung 16 aus. Der Gleichrichterverstärker 31 umfasst einen nicht invertierenden Verstärker 32 und einen invertierenden Verstärker 33, die in einer Ausführungsform betragsmäßig in etwa gleiche Verstärkungen aufweisen. Die Dioden 34 und 35 sorgen dafür, dass die jeweils höhere Spannung, die von den Verstärkern 32 und 33 geliefert wird, abzüglich der Diodenflussspannung von etwa 0,6 V am nicht invertierenden Eingang des Vergleichers 37 anliegt und mit der Referenzspannung verglichen wird. Um den richtigen Schwellenwert einzustellen, damit der Vorschub genau dann gestoppt wird, wenn der Fräser einen elektrischen Kontakt zu einem Kontaktpad herstellt, bieten sich zwei Parameter an, nämlich die Verstärkung der Verstärker 32 und 33 und die Höhe der Referenzspannung. Die Verstärkung kann beispielsweise fest vorgegeben oder als Grobeinstellung schrittweise jeweils um einem Faktor 10 verändert werden. Die Feineinstellung kann über die Referenzspannung erfolgen.

Fig. 3 entspricht weitgehend Fig. 2, wobei gleiche Bauteile mit gleichen Bezugszeichen bezeichnet wurden. Im Unterschied zu Fig. 2 ist in Fig. 3 der Kondensator 41 eingezeichnet. Er deutet an, dass bei dieser Ausführungsform der Fräser isoliert angeordnet ist und die Wechselspannung kapazitiv auf den Fräser eingekoppelt wird. Hierzu kann beispielsweise der Fräser leitend mit der Frässpindel verbunden sein, jedoch die Frässpindel gegenüber dem Rest und insbesondere dem Antriebsmotor der Fräsmaschine isoliert sein.

Für die Übertragung des Wechselspannungssignals auf die Frässpindel und dem Fräser kann in einer Ausführungsform das Maschinenbezugspotential des Maschinengehäuses verwendet werden.

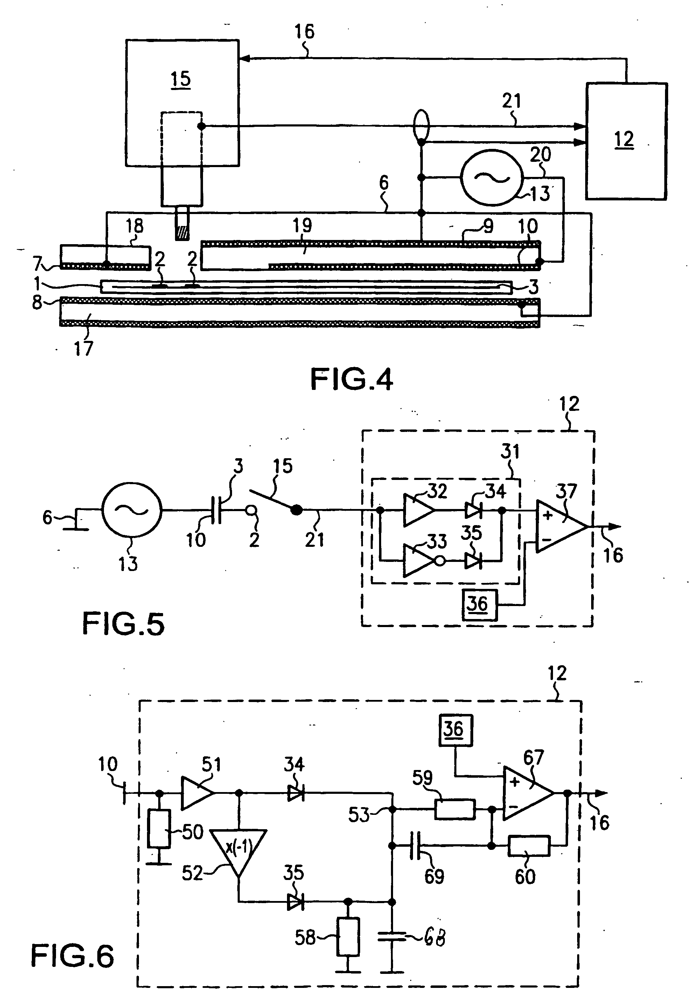

Fig. 4 zeigt eine zweite Ausführungsform einer erfindungsgemäßen Freilegevorrichtung. Im Unterschied zu der in Fig. 1 dargestellten Freilegevorrichtung ist bei dieser Ausführungsform die im Formwechselspannungsgenerator 13 erzeugte Wechselspannung zwischen die Elektrode 10 und die Planspannung 6 angelegt. Die Leitung 20 verbindet eine Elektrode des Wechselspannungsgenerators 13 mit der Elektrode 10. Der Eingang der Auswerteelektronik ist über Leitung 21 mit dem Fräskopf 15 verbunden. Die Leitung 21 kann abgeschirmt ausgeführt sein. Um die kapazitiv auf den Fräser und damit Spindel und Fräskopf gekoppelte Spannung möglichst wenig zu belasten, ist Leitung 21 möglichst kurz, so dass die Auswerteelektronik 12 möglichst nah am Fräser beispielsweise im Fräskopf oder zumindest im Fräsergehäuse untergebracht ist.

Fig. 5 zeigt ein Schaltbild der in Fig. 4 dargestellten Freilegevorrichtung, wobei die gleiche Auswertelektronik 12 wie in Fig. 2 und 3 verwendet wird. Zwischen der Planspannung 6 und der Elektrode 10 wird durch den Wechselspannungsgenerator 13 über eine elektrische Leitung eine Wechselspannung auf die Elektrode 10 gelegt. Die Elektrode selbst ist durch eine Platte eines Kondensators dargestellt. Die andere Kondensatorplatte bildet die Innenlage 3. Ein lösbarer Kontakt stellt die Kontaktpads 2 dar. Der Fräser des Fräskopfs 15 und die Kontaktpads 2 bilden einen Schalter, der über Leitung 21 mit dem Eingang der Auswerteelektronik 12 verbunden ist.

Fig. 6 zeigt eine weitere Ausführungsform der Auswerteelektronik 12. Diese Auswertelektronik dient dem Ziel, den Fräservorschub bereits zu verlangsamen, bevor der Fräser einen Kontaktpad kontaktiert. Zu diesem Zweck kann die Amplitude $U_e$ der an der Elektrode 10 abgegriffenen Spannung näherungsweise aus der Amplitude $U_f$ der am Fräser anliegenden Wechselspannung berechnet werden. So lange der Fräser den frei zu legenden Kontaktpad noch nicht berührt, bilden Fräser und Kontaktpad einen Kondensator der Kapazität C mit dem Blindwiderstand $X = (j\omega C)^{-1}$ ($j^2 = -1$, $\omega = 2\pi f$, f: Frequenz). Es wird angenommen, dass die Kapazität

$C_e$ zwischen Elektrode 10 und Innenlage 3 groß gegenüber der Kapazität C ist, so dass der Blindwiderstand $X_c$ klein gegen Blindwiderstand X ist und die Kapazität $C_e$ als leitende Verbindung angesehen werden kann. Die an der Elektrode 10 anliegende Spannung $U_e$ wird durch Streukapazitäten $X_{streu}$ gegenüber den Abschirmelektroden 7, 8 und 9 und den Innenwiderstand R der Auswerteelektronik belastet. Die Parallelschaltung aus Innenwiderstand und Streukapazität bildet einen komplexen Widerstand Z. Kondensator C und Widerstand Z bilden einen Spannungsteiler für die Amplitude $U_f$. Es ergibt sich:

$$U_e = U_f \frac{Z}{X + Z}$$

Unter der Annahme, dass X klein gegenüber Z ist und der Formel für die Kapazität eines Kondensators $C = \varepsilon A/d$, wobei $\varepsilon$ die Dielektrizitätskonstante, A die Überlappungsfläche zwischen Fräser und Kontaktpad sowie d der Abstand zwischen Fräser und Kontaktpad ist, ergibt sich:

$$U_e = U_f \frac{j\omega\varepsilon A Z}{d}$$

Unter den obigen Annahmen steigt die an der Elektrode 10 anliegende Spannung umgekehrt proportional zum Abstand d zwischen Fräser und Kontaktpad. Dieser Anstieg kann durch die in Fig. 6 dargestellte Schaltung vorteilhaft zur Verlangsamung des Fräserkopfvorschubs und damit zu einem genaueren Anhalten des Fräsers benutzt werden.

Die in Fig. 6 dargestellte Auswerteelektronik umfasst einen Verstärker 51, dessen Innenwiderstand R als Widerstand 50 dargestellt ist und möglichst hoch sein sollte, einen invertierenden Verstärker 52, zwei Dioden 34 und 35, zwei Kondensatoren 68 und 69, drei Widerstände 58, 59 und 60, einen Operationsverstärker 67 und eine Referenzspannungsquelle 36.

Der Operationsverstärker 67 ist als Differenzverstärker beschaltet, der eine hohe Ausgangsspannung liefert, wenn von der Elektrode 10 keine Wechselspannung geliefert wird und folglich am Knoten 53 lediglich eine geringe Spannung anliegt, die sich aus der durch die Widerstände 58, 59 und 60 herunter geteilten Ausgangspannung ergibt. Liefert die Elektrode 10 ein Wechselspannungssignal, so wird dies im Verstärker 51 verstärkt und über den invertierenden Verstärker 52 und die beiden Dioden 34, 35 zweiweg gleichgerichtet.

Somit steigt die Spannung am Punkt 53 an. Kondensator 68 glättet die von den Dioden 34 und 35 gelieferte pulsierende Gleichspannung. Durch den Spannungsanstieg am Punkt 53 sinkt die Ausgangspannung an der Vorschubsteuerleitung 16. Der Kondensator 69 dient dazu, dass bei einem schnellen Anstieg der Amplitude der an der Elektrode 10 anliegenden Wechselspannung und einem daraus resultierenden schnellen Anstieg der am Punkt 53 anliegenden Spannung die an der Vorschubsteuerleitung 16 ausgegebene Spannung zusätzlich abgesenkt wird. Somit wird eine Proportional-Differenzial(PI)-Regelung des Fräservorschubs erreicht.

In einer anderen Ausführungsform kann beispielsweise die am Punkt 53 anliegende Spannung digitalisiert werden und die Fräsersteuerung digital über einen Mikrocontroller erfolgen. Auch der Mikrokontroller kann die digitalisierte Spannung näherungsweise nach der Zeit ableiten und aus dem Spannungswert und seiner zeitlichen Ableitung eine PI-Regelung des Fräservorschubs realisieren.

**Bezugszeichenliste**

| | |
|---|---|
| 1 | Chipkarte |
| 2 | Kontaktpads |
| 3 | Innenlage, z. B. Antenne |
| 6 | Planspannung |
| 7,8,9 | Abschirmungselektrode |
| 10 | Elektrode |
| 11 | Leitung (abgeschirmt) |
| 12 | Auswertelektronik |
| 13 | Wechselspannungsgenerator |
| 14 | Wechselspannungsanschluss |
| 15 | Fräskopf mit Vorschubsteuerung, Spindel und Fräser |
| 16 | Vorschubsteuerleitung |
| 17 | Kartenauflage |
| 18,19 | Niederhalter |
| 20 | Leitung |
| 21 | Leitung (abgeschirmt) |
| 31 | Gleichrichterverstärker |
| 32 | nicht invertierender Verstärker |
| 33 | invertierender Verstärker |
| 34,35 | Diode |
| 36 | Referenzspannungsquelle |
| 37 | Vergleicher |
| 41 | Kondensator |
| 50 | innerer Widerstand von Verstärker 51 |
| 51 | Verstärker |
| 52 | invertierender Verstärker |
| 53 | Knoten |
| 58,59,60 | Widerstände |
| 67 | Operationsverstärker |
| 68,68 | Kondensatoren |

**Patentansprüche**

1.  Freilegevorrichtung zum Freilegen von elektrisch leitenden Materialien (2) in nicht leitenden Trägem (1) mit:

    einer Entfernungseinrichtung (15) zum Entfernen von Material des nicht leitenden Trägers (1), deren Vorschub steuerbar ist;

einer Vorschubsteuerungseinrichtung (11, 12, 16) zum Steuern des Vorschubs der Entfernungseinrichtung (15);

einer Elektrode (10) zum Erfassen einer Spannung, wobei ein Eingang der Vorschubsteuerungseinrichtung mit der Elektrode leitend verbunden ist und die Vorschubsteuerungseinrichtung (11, 12, 16) den Vorschub der Entfernungseinrichtung (15) in Abhängigkeit von der an der Elektrode (10) anliegenden Spannung steuert,
**gekennzeichnet durch**

eine erste und eine zweite flächige Abschirmelektrode (7, 8, 9), wobei die Abschirmelektroden leitend miteinander verbunden sind und eine Wechselspannung zwischen der Entfernungseinrichtung (15) und den Abschirmelektroden (7, 8, 9) angelegt ist, und **dadurch**, dass

die erste und zweite Abschirmelektrode so angeordnet sind, dass sich der Träger (1) bei der Bearbeitung zwischen den Abschirmelektroden befindet.

2.  Freilegevorrichtung zum Freilegen von elektrisch leitenden Materialien (2) in nicht leitenden Trägem (1) mit:

    einer Entfernungseinrichtung (15) zum Entfernen von Material des nicht leitenden Trägers (1), deren Vorschub steuerbar ist;

    einer Vorschubsteuerungseinrichtung (21, 12, 16) zum Steuem des Vorschubs der Entfernungseinrichtung (15);

    einer Elektrode (10) zum Anlegen einer Spannung, wobei ein Eingang der Vorschubsteuerungseinrichtung mit der Entfernungseinrichtung (15) leitend verbunden ist und die Vorschubsteuerungseinrichtung (12, 16, 21) den Vorschub der Entfernungseinrichtung (15) in Abhängigkeit von der an der Entfernungseinrichtung (15) anliegenden Spannung steuert,
    **gekennzeichnet durch**

    eine erste und eine zweite flächige Abschirmelektrode (7, 8, 9), wobei die Abschirmelektroden leitend miteinander verbunden sind und eine Wechselspannung zwischen der Elektrode (10) und den Abschirmelektroden (7, 8, 9) angelegt ist, und **dadurch**, dass

die erste und zweite Abschirmelektrode so angeordnet sind, dass sich der Träger (1) bei der Bearbeitung zwischen den Abschirmelektroden befindet.

3. Freilegevorrichtung nach Anspruch 1 oder 2, **dadurch gekennzeichnet, dass** die Entfernungseinrichtung ein Fräser (15) ist.

4. Freilegevorrichtung nach einem der obigen Ansprüche, **dadurch gekennzeichnet, dass** die Elektrode (10) zwischen den zwei Abschirmelektroden angeordnet ist.

5. Freilegevorrichtung nach einem der obigen Ansprüche, **dadurch gekennzeichnet, dass** die elektrisch leitenden Materialien in nicht leitenden Trägem eine Chipkarte (1) bilden und die elektrisch leitenden Materialien einer Innenlage (3) mit Kontaktpads (2) entsprechen, wobei die Innenlänge beispielsweise eine Antenne bilden kann.

6. Freilegevorrichtung nach Anspruch 5, **dadurch gekennzeichnet, dass** sich der Platz für die Chipkarte (1) zwischen einer Kartenauflage (17) und einem Niederhalter (18,19) befindet und sich sowohl auf der Kartenauflage (17) als auch auf dem Niederhalter (18, 19) je eine flächige Abschirmelektrode (7, 8, 9) befindet.

7. Freilegevorrichtung nach Anspruch 6, **dadurch gekennzeichnet, dass** der Niederhalter eine Öffnung für einen Fräser aufweist, wobei sich unterhalb der Öffnung die frei zu legenden elektrisch leitenden Materialien (2) befinden.

8. Freilegevorrichtung nach einem der obigen Ansprüche, **dadurch gekennzeichnet, dass** die Vorschubsteuerungseinrichtung den Vorschub stoppt, wenn die dem Eingang der Vorschubsteuerungseinrichtung (12) zugeführte Spannung einen ersten Grenzwert unter- oder einen zweiten Grenzwert überschreitet.

9. Freilegevorrichtung nach Anspruch 8, **dadurch gekennzeichnet, dass** die Vorschubsteuerungseinrichtung einen nicht invertierenden Verstärker (32) und einen invertierenden Verstärker (33) umfasst, denen die Spannung am Eingang der Vorschubsteuerungseinrichtung (12) zugeführt wird, wobei die Ausgänge der beiden Verstärker über Dioden (34, 35) mit einem Vergleicher (37) verbunden sind, wobei das Ausgangssignal des Vergleichers zum Abschalten des Vorschubs verwendet wird.

10. Freilegevorrichtung nach einem der Ansprüche 3 bis 9, soweit sich die Ansprüche 4, 5 und 8 auf den Anspruch 3 rückbeziehen, **dadurch gekennzeich-**

**net, dass** der Fräser (15) gegenüber seinem Antrieb elektrisch isoliert ist und die Wechselspannung kapazitiv auf den Fräser gekoppelt ist.

11. Freilegevorrichtung nach einem der obigen Ansprüche, **dadurch gekennzeichnet, dass** die Vorschubsteuerungseinrichtung (12) die Vorschubgeschwindigkeit um so mehr verlangsamt, je höher die Amplitude der dem Eingang der Vorschubsteuerungseinrichtung zugeführten Spannung ist.

12. Freilegevorrichtung nach einem der obigen Ansprüche, **dadurch gekennzeichnet, dass** die Vorschubsteuerungseinrichtung (12) die Vorschubgeschwindigkeit um so mehr verlangsamt, je schneller die Amplitude der dem Eingang der Vorschubsteuerungseinrichtung zugeführten Spannung ansteigt.

13. Verfahren zur Steuerung einer Freilegevorrichtung zum Freilegen von elektrisch leitenden Materialien (2) in nicht leitenden Trägem (1) mit den Schritten:

Entfernen von Material des nicht leitenden Trägers (1), wobei eine Entfernungseinrichtung (15) mit einer Vorschubgeschwindigkeit in das Material des nicht leitenden Trägers (1) vorgeschoben wird;

Anlegen einer Wechselspannung zwischen der Entfernungseinrichtung (15) und einer ersten und einer zweiten flächigen Abschirmelektrode (7, 8, 9), wobei die Abschirmelektroden leitend miteinander verbunden sind und die erste und zweite Abschirmelektrode so angeordnet sind, dass sich der Träger (1) bei der Bearbeitung zwischen den Abschirmelektroden befindet;

Messen der an einer Elektrode (10) anliegenden Spannung und Steuern der Vorschubgeschwindigkeit in Abhängigkeit von der an der Elektrode (10) anliegenden Spannung

14. Verfahren gemäß Anspruch 13, **dadurch gekennzeichnet, dass** der Vorschub gestoppt wird, sobald die an der Elektrode gemessene Spannung einen vorbestimmten Wert überschreitet.

15. Verfahren nach Anspruch 13 oder 14, **dadurch gekennzeichnet, dass** die Vorschubgeschwindigkeit um so langsamer eingestellt wird, je höher die Amplitude der an der Elektrode gemessenen Spannung ist.

16. Verfahren nach einem der Ansprüche 13 bis 15, **dadurch gekennzeichnet, dass** die Vorschubgeschwindigkeit um so langsamer eingestellt wird, je schneller die Amplitude der an der Elektrode gemessenen Spannung steigt.

**17.** Verfahren zur Steuerung einer Freilegevorrichtung zum Freilegen von elektrisch leitenden Materialien (2) in nicht leitenden Trägem (1) mit den Schritten:

Entfernen von Material des nicht leitenden Trägers (1), wobei eine Entfernungseinrichtung (15) mit einer Vorschubgeschwindigkeit in das Material des nicht leitenden Trägers (1) vorgeschoben wird;

Anlegen einer Wechselspannung zwischen einer Elektrode (10) und einer ersten und einer zweiten flächigen Abschirmelektrode (7, 8, 9), wobei die Abschirmelektroden leitend miteinander verbunden sind und die erste und zweite Abschirmelektrode so angeordnet sind, dass sich der Träger (1) bei der Bearbeitung zwischen den Abschirmelektroden befindet;

Auswerten der an der Entfernungseinrichtung (15) anliegenden Spannung zum Steuern der Vorschubgeschwindigkeit in Abhängigkeit von der an der Entfernungseinrichtung anliegenden Spannung.

**18.** Verfahren gemäß Anspruch 17, **dadurch gekennzeichnet, dass** der Vorschub gestoppt wird, sobald die an der Entfernungseinrichtung anliegende Spannung einen vorbestimmten Wert überschreitet.

**19.** Verfahren nach Anspruch 17 oder 18, **dadurch gekennzeichnet, dass** die Vorschubgeschwindigkeit um so langsamer eingestellt wird, je höher die Amplitude der an der Entfernungseinrichtung anliegenden Spannung ist.

**20.** Verfahren nach einem der Ansprüche 17 bis 19, **dadurch gekennzeichnet, dass** die Vorschubgeschwindigkeit um so langsamer eingestellt wird, je schneller die Amplitude der an der Entfernungseinrichtung anliegenden Spannung ansteigt.

**Claims**

**1.** Uncovering device for uncovering electroconductive materials (2) in electrically insulating carriers (1), comprising:

a removal device (15) for removing Material of said electrically insulating carrier (1), wherein the infeed of said removal device (15) can be controlled;

an infeed control device (11, 12, 16) for controlling the infeed of the removal device (15);

an electrode (10) for detecting a voltage, wherein an input of the infeed control device (12) is conductively connected to the electrode (10) and wherein the infeed control device (11, 12, 16) controls the infeed of the removal device (15) in dependence on the voltage present at the electrode (10);

**characterized in**

a first and a second planar screening electrode (7, 8, 9), wherein said screening electrodes are conductively connected to each other, an alternating voltage being applied between the removal device (15) and the screening electrodes (7, 8, 9), and

that said first and second screening electrodes are arranged in way that said electrically insulating carrier (1) is located between said screening electrodes (7, 8, 9) when being processed.

**2.** Uncovering device for uncovering electroconductive materials (2) in electrically insulating carriers (1), comprising:

a removal device (15) for removing material of said electrically insulating carrier (1), wherein the infeed of said removal device (15) can be controlled;

an infeed control device (21, 12, 16) for controlling the infeed of the removal device (15);

an electrode (10) for applying a voltage, wherein an input of the infeed control device (21, 12, 16) is conductively connected to the removal device (15) and wherein the infeed control device (12) controls the infeed of the removal device (15) in dependence on the voltage present at the removal device (15);

**characterized in**

a first and a second planar screening electrode (7, 8, 9), wherein said screening electrodes are conductively connected to each other, an alternating voltage being applied between the electrode (10) and the screening electrodes (7, 8, 9), and

that said first and second screening electrodes are arranged in way that said electrically insulating carrier (1) is located between said screening electrodes (7, 8, 9) when being processed.

**3.** Uncovering device according to claim 1 or 2, **characterized in that** the removal device (15) is a milling cutter.

**4.** Uncovering device according to one of the preceding claims, **characterized in that** said electrode (10) is arranged between said two screening electrodes.

**5.** Uncovering device according to one of the preceding claims, **characterized in that** said electroconductive materials in electrically insulating carriers form a chip card (1) and that the electroconductive Material correspond to an interior layer (3) with contact pads (2), wherein said interior layer may form for instance an antenna.

**6.** Uncovering device according to claim 5, **characterized in that** the location for said chip card (1) is disposed between a card support (17) and a pressure pad (18, 19), and that on the card support (17) as well as on the pressure pad (18,19) a planar screening electrode (7, 8, 9) is located.

**7.** Uncovering device according to claim 6, **characterized in that** the pressure pad comprises an opening for a milling cutter, the electroconductive materials (2) to be uncovered being located below the opening.

**8.** Uncovering device according to one of the preceding claims, **characterized in that** the infeed control device (12) stops the infeed, if the voltage supplied to the input of the infeed control device (12) falls below a first limiting value or exceeds a second limiting value.

**9.** Uncovering device according to claim 8, **characterized in that** the infeed control device (12) includes a non-inverting amplifier (32) and an inverting amplifier (33) to which the voltage is supplied at the input of the infeed control device (12), the outputs of the two amplifiers being connected to a comparator (37) via diodes (34, 35), the output signal of the comparator being used for switching off the infeed.

**10.** Uncovering device according to one of the claims 3 to 9, as far as claims 4, 5 and 8 depend on claim 3, **characterized in that** the milling cutter (15) is electrically insulated with respect to its drive and the alternating voltage is capacitively coupled to the milling cutter.

**11.** Uncovering device according to one of the preceding claims, **characterized in that** the infeed control device (12) increasingly slows down the rate of infeed with the increase of the amplitude of the voltage applied to the input of said infeed control device.

**12.** Uncovering device according to one of the preceding claims, **characterized in that** the infeed control device (12) increasingly slows down the rate of feed as the amplitude of the voltage applied to the input of said infeed control device increases more quickly.

**13.** Method for controlling an uncovering device for uncovering electroconductive materials (2) in electrically insulating carriers (1), comprising the steps of:

removing material of the electrically insulating carrier (1), a removal device (15) being fed into the material of the nonconducting carrier (1) with a rate of infeed;

applying an alternating voltage between the removal device (15) and a first and second planar screening electrode (7, 8, 9), wherein said screening electrodes are conductively connected to each other and wherein said first and second screening electrodes are arranged in a way, that said electrically insulating carrier (1) is located between said screening electrodes when being processed;

detecting the voltage at an electrode (10) and controlling the rate of infeed in dependence on the voltage at said electrode (10).

**14.** Method according to claim 13, **characterized in that** the infeed is stopped as soon as the voltage detected at the electrode exceeds a predetermined value.

**15.** Method according to claim 13 or 14, **characterized in that** the rate of infeed is adjusted to be slower as the amplitude of the voltage detected at the electrode is becoming higher.

**16.** Method according to one of the claims 13 to 15, **characterized in that** the rate of infeed is adjusted to be slower as the amplitude of the voltage detected at the electrode is increasing more quickly.

**17.** Method for controlling an uncovering device for uncovering electroconductive materials (2) in electrically insulating carriers (1), comprising the steps of:

removing material of the electrically insulating carrier (1), a removal device (15) being fed into the material of the nonconducting carrier (1) with a rate of infeed;

applying an alternating voltage between an electrode (10) and a first and second planar screening electrode (7, 8, 9), wherein said screening electrodes are conductively connected to each other and wherein said first and second screening electrodes are arranged in a way, that said electrically insulating carrier (1) is located between said screening electrodes when being processed;

evaluating the voltage applied to the removal device (15) for controlling the rate of infeed in dependence on the voltage applied to the removal device.

18. Method according to claim 17, **characterized in that** the infeed is stopped as soon as the voltage applied to the removal device exceeds a predetermined value.

19. Method according to claim 17 or 18, **characterized in that** the rate of infeed is adjusted to be slower as the amplitude of the voltage applied to the removal device is becoming higher.

20. Method according to one of the claims 17 to 19, **characterized in that** the rate of infeed is adjusted to be slower as the amplitude of the voltage applied to the removal device is increasing more quickly.

**Revendications**

1. Dispositif de dénudation pour dénuder des matériaux électriquement conducteurs (2) dans des substrats non conducteurs (1), comprenant :

   - un dispositif d'enlèvement (15) dont l'avance peut être commandée pour enlever de la matière du substrat non conducteur (1) ;
   - un dispositif de commande d'avance (11, 12, 16) pour commander l'avance du dispositif d'enlèvement ; et
   - une électrode (10) pour détecter une tension, une entrée du dispositif de commande d'avance étant reliée de manière conductrice à l'électrode et le dispositif de commande d'avance (11, 12, 16) commandant l'avance du dispositif d'enlèvement (15) en fonction de la tension appliquée sur l'électrode (10),

     **caractérisé par** :

   - une première et une seconde électrode de blindage surfacique (7, 8, 9), les électrodes de blindage étant reliées entre elles de manière conductrice et une tension alternative étant appliquée entre le dispositif d'enlèvement (15) et les électrodes de blindage (7, 8, 9) ; et
   - le fait que la première et la seconde électrode de blindage sont agencées de sorte que le substrat (1) se trouve entre les électrodes de blindage pendant l'usinage.

2. Dispositif de dénudation pour dénuder des matériaux électriquement conducteurs (2) dans des substrats non conducteurs (1), comprenant :

   - un dispositif d'enlèvement (15) dont l'avance peut être commander pour enlever de la matière du substrat non conducteur (1) ;
   - un dispositif de commande d'avance (21, 12, 16) pour commander l'avance du dispositif d'enlèvement (15) ; et
   - une électrode (10) pour appliquer une tension, une entrée du dispositif de commande d'avance étant reliée de manière conductrice au dispositif d'enlèvement (15) et le dispositif de commande d'avance (12, 16, 21) commandant l'avance du dispositif d'enlèvement (15) en fonction de la tension appliquée sur le dispositif d'enlèvement (15),

     **caractérisé :**

   - **par** une première et une seconde électrode de blindage surfacique (7, 8, 9), les électrodes de blindage étant reliées entre elles de manière conductrice et une tension alternative étant appliquée entre l'électrode (10) et les électrodes de blindage (7, 8, 9) ; et
   - **par** le fait que la première et la seconde électrode de blindage sont agencées de sorte que le substrat (1) se trouve entre les électrodes de blindage pendant l'usinage.

3. Dispositif de dénudation selon la revendication 1 ou 2, **caractérisé en ce que** le dispositif d'enlèvement est une fraise (15).

4. Dispositif de dénudation selon l'une quelconque des revendications précédentes, **caractérisé en ce que** l'électrode (10) est agencée entre les deux électrodes de blindage.

5. Dispositif de dénudation selon l'une des revendications précédentes, **caractérisé en ce que** les matériaux électriquement conducteurs dans des substrats non conducteurs forment une carte à puce (1) et correspondent aux matériaux électriquement conducteurs d'une couche intérieure (3) avec des coussinets de contact (2), la couche intérieure (3) pouvant former par exemple une antenne.

6. Dispositif de dénudation selon la revendication 5, **caractérisé en ce que** l'emplacement de la carte à puce (1) se trouve entre un support de carte (17) et un serre-flan (18, 19) et **en ce qu'**une électrode de blindage surfacique (7, 8, 9) se trouve aussi bien sur le support de carte (17) que sur le serre-flan (18, 19).

7. Dispositif de dénudation selon la revendication 6, **caractérisé en ce que** le serre-flan présente une ouverture pour une fraise, les matériaux électriquement conducteurs (2) qui doivent être dénudés se trouvant en dessous de l'ouverture.

8. Dispositif de dénudation selon l'une quelconque des revendications précédentes, **caractérisé en ce que** le dispositif de commande d'avance arrête l'avance lorsque la tension amenée vers l'entrée du dispositif de commande d'avance (12) est inférieure à une première valeur limite ou est supérieure à une seconde valeur limite.

9. Dispositif de dénudation selon la revendication 8, **caractérisé en ce que** le dispositif de commande d'avance comporte un amplificateur non inversant (32) et un amplificateur inversant (33) dont la tension est amenée sur l'entrée du dispositif de commande d'avance (12), les sorties des deux amplificateurs étant reliées à un comparateur (37) au moyen de diodes (34, 35) et le signal de sortie du comparateur étant utilisé pour déconnecter l'avance.

10. Dispositif de dénudation selon l'une des revendications 3 à 9, dans la mesure où les revendications 4, 5 et 8 se réfèrent en retour à la revendication 3, **caractérisé en ce que** la fraise (15) est isolée électriquement par rapport à son entraînement et **en ce que** la tension alternative est couplée de manière capacitive sur la fraise.

11. Dispositif de dénudation selon l'une quelconque des revendications précédentes, **caractérisé en ce que**, plus l'amplitude de la tension amenée vers l'entrée du dispositif de commande d'avance est élevée, plus le dispositif de commande d'avance (12) ralentit la vitesse d'avance.

12. Dispositif de dénudation selon l'une des revendications ci-dessus, **caractérisé en ce que**, plus l'amplitude de la tension amenée vers l'entrée du dispositif de commande d'avance augmente rapidement, plus le dispositif de commande d'avance (12) ralentit la vitesse d'avance.

13. Procédé pour commander un dispositif de dénudation pour dénuder des matériaux électriquement conducteurs (2) dans des substrats non conducteurs (1), comprenant les étapes suivantes consistant à:

    - enlever de la matière du substrat non conducteur (1), opération pendant laquelle un dispositif d'enlèvement (15) est avancé avec une vitesse d'avance dans le matériau du substrat non conducteur (1) ;
    - appliquer une tension alternative entre le dispositif d'enlèvement (15) et une première et une seconde électrode de blindage surfacique (7, 8, 9), les électrodes de blindage étant reliées entre elles de manière conductrice et la première et la seconde électrode de blindage étant agencées de sorte que le substrat (1) se trouve entre les électrodes de blindage pendant l'usinage ; et
    - mesurer la tension appliquée sur une électrode (10) et commander la vitesse d'avance en fonction de la tension appliquée sur l'électrode (10).

14. Procédé selon la revendication 13, **caractérisé en ce que** l'avance est arrêtée dès que la tension mesurée sur l'électrode dépasse une valeur prédéterminée.

15. Procédé selon la revendication 13 ou 14, **caractérisé en ce que**, plus l'amplitude de la tension mesurée sur l'électrode est élevée, plus la vitesse d'avance est ajustée sur une valeur lente.

16. Procédé selon l'une des revendications 13 à 15, **caractérisé en ce que**, plus l'amplitude de la tension mesurée sur l'électrode augmente rapidement, plus la vitesse d'avance est ajustée sur une valeur lente.

17. Procédé de commande d'un dispositif de dénudation pour dénuder des matériaux électriquement conducteurs (2) dans des substrats non conducteurs (1), comprenant les étapes suivantes consistant à:

    - enlever de la matière du substrat non conducteur (1), opération pendant laquelle un dispositif d'enlèvement (15) est avancé avec une vitesse d'avance dans le matériau du substrat non conducteur (1) ;
    - appliquer une tension alternative entre une électrode (10) et une première et une seconde électrode de blindage surfacique (7, 8, 9), les électrodes de blindage étant reliées entre elles de manière conductrice et la première et la seconde électrode de blindage étant agencées de sorte que le substrat (1) se trouve entre les électrodes de blindage pendant l'usinage ; et
    - interpréter la tension appliquée sur le dispositif d'enlèvement (15) pour commander la vitesse d'avance en fonction de la tension appliquée sur le dispositif d'enlèvement (15).

18. Procédé selon la revendication 17, **caractérisé en ce que** l'avance est arrêtée dès que la tension mesurée sur le dispositif d'enlèvement dépasse une valeur prédéterminée.

19. Procédé selon la revendication 17 ou 18, **caractérisé en ce que**, plus l'amplitude de la tension mesurée sur le dispositif d'enlèvement est élevée, plus la vitesse d'avance est ajustée sur une valeur lente.

20. Procédé selon l'une des revendications 17 à 19, **caractérisé en ce que**, plus l'amplitude de la tension mesurée sur le dispositif d'enlèvement augmente rapidement, plus la vitesse d'avance est ajustée sur une valeur lente.

**FIG.1**

**FIG.2**

**FIG.3**

FIG.4

FIG.5

FIG.6